## Europäisches Patentamt
## European Patent Office
## Office européen des brevets

(19)

(11) Veröffentlichungsnummer: **0 169 452 B1**

(12) **EUROPÄISCHE PATENTSCHRIFT**

(45) Veröffentlichungstag der Patentschrift: 05.06.91

(51) Int. Cl.⁵ **G11C 11/408,** G11C 11 24

(21) Anmeldenummer: **85108682.7**

(22) Anmeldetag: **11.07.85**

(54) **Integrierte Schaltung eines in komplementärer Schaltungstechnik aufgebauten dynamischen Halbleiterspeichers.**

(30) Priorität: **25.07.84 DE 3427454**

(43) Veröffentlichungstag der Anmeldung:
**29.01.86 Patentblatt 86/05**

(45) Bekanntmachung des Hinweises auf die
Patenterteilung:
**05.06.91 Patentblatt 91/23**

(84) Benannte Vertragsstaaten:
**AT DE FR GB IT NL**

(56) Entgegenhaltungen:
**DE-A- 2 443 490**
**DE-A- 2 443 490**
**US-A- 4 145 622**

**IEEE TRANSACTIONS ON ELECTRON DEVI-
CES, Band ED-29, Nr. 4, April 1982, Seiten
714-718, IEEE, New York, US; K. SHIMOHI-
GASHI et al.: "An n-Well CMOS dynamic
RAM"**

**ELECTRONICS & COMMUNICATIONS IN JA-
PAN, Band 66, Nr. 9, September 1983, Seiten
100-106, Scripta Publishing Co., Silver
Spring, Maryland, US; T. YOSHIHARA et al.:
"Influences of circuit design on the charac-**

teristics of soft error in MOS dynamic
RAMs"

**IBM TECHNICAL DISCLOSURE BULLETIN,
Band 25, Nr. 4, September 1982, Seiten
2135-2136, New York, US; L.M. TERMAN:
"CMOS decoder circuit"**

(73) Patentinhaber: **Siemens Aktiengesellschaft
Wittelsbacherplatz 2
W-8000 München 2(DE)**

(72) Erfinder: **Schütz, Alfred, Dr.-Ing.
Lindenstrasse 22
W-8011 Zorneding(DE)**
Erfinder: **Müller, Wolfgang, Dr.-Ing.
Theodor-Heuss-Strasse 12
W-8011 Putzbrunn(DE)**
Erfinder: **Soutschek, Ewald, Dr.-Ing.
Theodor-Heuss-Strasse 8
W-8011 Putzbrunn(DE)**

## Beschreibung

Die Erfindung bezieht sich auf eine integrierte Schaltung eines in komplementärer Schaltungstechnik aufgebauten dynamischen Halbleiterspeichers mit wahlfreiem Zugriff nach dem Oberbegriff des Patentanspruchs 1.

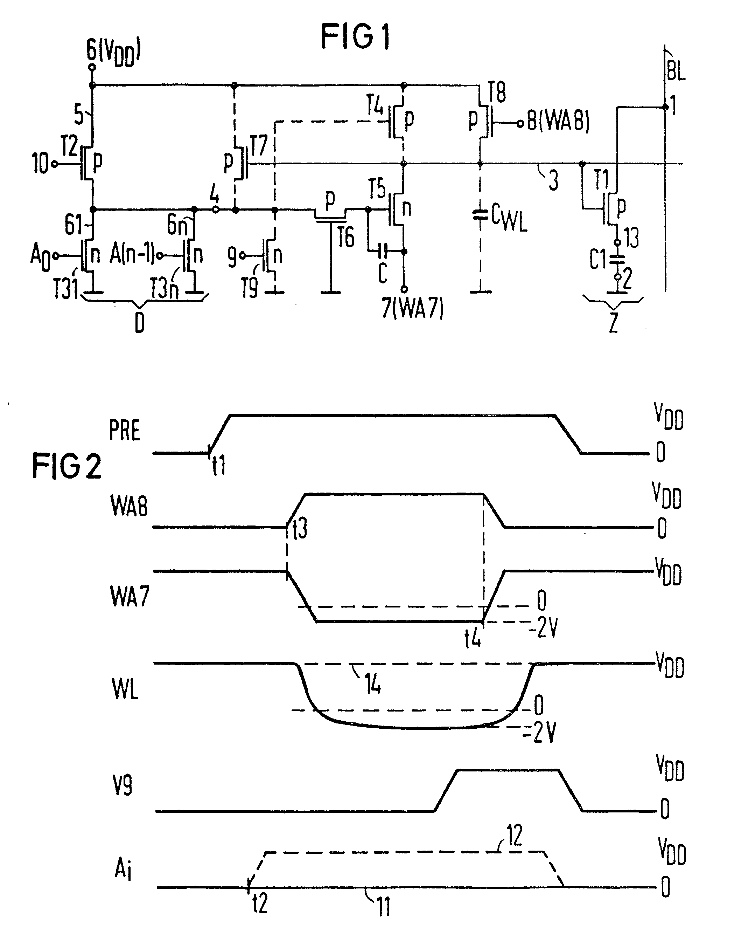

Eine solche Schaltung ist beispielsweise aus den IEEE Transactions on Electron Devices, Vol. ED-29, No. 4, April 1982, Seiten 714-718, insbesondere Fig. 2, bekannt. Hierbei handelt es sich um p-Kanal-Auswahltransistoren und n-Kanal-Schalttransistoren, über die die Wortleitungen jeweils vom nichtselektierten Zustand in den selektierten Zustand geschaltet werden. Die hierzu erforderliche Umladung der Wortleitungskapazitäten erfolgt zwar schneller, als dies bei n-Kanal-Auswahltransistoren der Fall wäre, doch kann der Speicherkondensator einer adressierten Speicherzelle über einen p-Kanal-Auswahltransistor und einen n-Kanal-Schalttransistor nur auf ein Potential entladen werden, das der Einsatzspannung des Auswahltransistors entspricht. Ein weiteres Absinken der Spannung am Speicherkondensator wird durch das Sperren des Auswahltransistors verhindert. Somit steht nicht der volle durch die Versorgungsspannung und das Bezugspotential gegebene Spannungshub für die Speicherung digitaler Signale zur Verfügung.

Aus der Offenlegungsschrift DE 2 443 490 Al des Deutschen Patentamts ist insbesondere aus Figur 8 ein Schalter aus MOS-Transistoren bekannt, mit dem bei Adressendecodern für MOS-Speicherbausteine ein Taktsignal zeitgerecht mit einem Steuersignal durchgeschaltet wird. Der Schalter aus MOS-Transistoren weist nur MOS-Transistoren gleichen Kanaltyps auf und kann eine Wortleitung nur auf einen Spannungswert vorladen der zwischendem Wert der Versorgungsspannung und dem des Bezugspotentials liegt.

Der Erfindung liegt die Aufgabe zugrunde, eine integrierte Schaltung der eingangs genannten Art anzugeben, bei der dieser Nachteil nicht auftritt. Das wird erfindungsgemäß durch eine Ausbildung der Schaltung nach dem kennzeichnenden Teil des Patentanspruchs 1 erreicht.

Der mit der Erfindung erzielbare Vorteil besteht insbesondere darin, daß auf der Wortleitung eine so große Potentialdifferenz zwischen den beiden im selektierten und im nichtselektierten Zustand herrschenden Potentialzuständen erreicht wird, daß der den Speicherzellen über die Bitleitungen zuführbare volle Spannungshub, der durch die Versorgungsspannung und das Bezugspotential gegeben ist, für die Speicherung von digitalen Signalen zur Verfügung steht.

Die Ansprüche 2 bis 5 sind auf bevorzugte Ausgestaltungen und Weiterbildungen der Erfindung gerichtet.

Die Erfindung wird nachfolgend anhand der Zeichnung näher beschrieben. Dabei zeigt:

Fig. 1    ein bevorzugtes Ausführungsbeispiel der Erfindung und

Fig. 2    Spannungs-Zeitdiagramme zur Erläuterung von Fig. 1.

In Fig. 1 ist die Speicherzelle eines dynamischen Halbleiterspeichers mit wahlfreiem Zugriff (DRAM) mit Z bezeichnet. Sie enthält einen p-Kanal-Auswahltransistor T1 und einen Speicherkondensator C1. Beide sind zueinander in Serie geschaltet und liegen zwischen dem Anschluß 1 einer Bitleitung BL und einem Anschluß 2, der mit einem Bezugspotential beschaltet ist. Zur Adressierung der Speicherzelle Z dient eine Wortleitung 3, die mit dem Gate von T1 verbunden ist. Im nichtselektierten Zustand der Wortleitung 3 liegt diese auf einem Spannungspegel, der der Versorgungsspannung $V_{DD}$ entspricht, während sie im selektierten Zustand, in dem der Speicherkondensator C1 über den leitenden Auswahltransistor T1 an die Bitleitung BL angeschaltet ist, auf ein niedriges Potential gelegt wird. Die potentialmäßige Ansteuerung der Wortleitung 3 erfolgt über den Ausgang 4 eines Dekoders D, der in einem ersten Schaltzweig 5 einen p-Kanal-Transistor T2 und in n zweiten Schaltzweigen 61 bis 6n jeweils einen n-Kanal-Transistor T31 bis T3n aufweist. Der Schaltzweig 5 liegt zwischen einem Anschluß 6, der mit der Versorgungsspannung $V_{DD}$ beschaltet ist, und dem Ausgang 4, während die Schaltzweige 61 bis 6n jeweils zwischen 4 und dem Bezugspotential der Schaltung liegen.

Der Ausgang 4 des Dekoders D ist mit dem Gate eines n-Kanal-Transistors T5 verbunden, über den die Wortleitung 3 an einen Anschluß 7 geführt ist. In die Verbindung des Ausgangs 4 mit dem Gate von T5 ist ein p-Kanal-Transistor T6 eingefügt, dessen Gate auf Bezugspotential liegt. Das Gate von T5 ist über eine Kapazität C mit dem Anschluß 7 verbunden. Ein p-Kanal-Transistor T8, der zwischen den Anschluß 6 und die Wortleitung 3 geschaltet ist, ist mit einem Gateanschluß 8 versehen. Die Leitungskapazität der Wortleitung 3 ist schließlich durch eine Kapazität $C_{WL}$ angedeutet, deren Anschlußleitungen gestrichelt dargestellt sind.

Vor einem Adressiervorgang ist die Wortleitung 3 über den leitenden Transistor T8 mit der Versorgungsspannung $V_{DD}$ belegt. Hierzu wird dem Gateanschluß 8 eine Spannung WA8 (Fig. 2) zugeführt. die 0 Volt beträgt. Zu Beginn des Adressiervorgangs, d.h. zum Zeitpunkt t1, wird nun die am Gateanschluß 10 von T2 anliegende Spannung PRE von 0 Volt auf $V_{DD}$ angehoben, wodurch der Ausgang 4, der sich vor t1 bei leitendem Transistor T2 auf $V_{DD}$ aufgeladen hatte, durch das Sperren von T2 von $V_{DD}$ abgeschaltet wird. 4 befindet sich dann im Zustand des "floating", solange PRE auf $V_{DD}$ liegt. Zum Zeitpunkt t2 werden n Adressensignale $A_0$ bis $A_{(n-1)}$ den entsprechend bezeichneten Gateanschlüssen von T31 bis T3n zugeführt, was in Fig. 2 durch den Spannungsverlauf $A_i$ angedeutet ist. Haben sämtliche Adressensignale einen Wert von 0 Volt, was in Fig. 2 durch den mit 11 bezeichneten Verlauf von $A_i$ angedeutet ist, so bleiben alle Transistoren T 31 bis T3n gesperrt (Selektion der Wortleitung 3). Das bedeutet, daß sich der Ausgang 4 während des Adressiervorgangs nicht wesentlich entlädt. Dabei wird die Wortleitung 3 so angesteuert, daß sie während des ganzen Adressiervorgangs auf ein niedriges Potential entladen wird, wie weiter unten im einzelnen erläutert wird. Die Auswahltransistoren, z.B. T1, der an 3 liegenden Speicherzellen , z.B. Z, werden leitend und schalten die Speicherkondensatoren, z.B. C1, an die zugehörigen Bitleitungen BL (Adressierung der Speicherzellen).

Wenn andererseits wenigstens eines der Adressensignale $A_0$ bis $A_{(n-1)}$ einen Wert von $V_{DD}$ annimmt, was durch den gestrichelt gezeichneten Verlauf 12 von $A_i$ ausgedrückt wird, entlädt sich der Ausgang 4 auf 0 Volt, was dazu führt, daß die Wortleitung 3 während des ganzen Adressiervorgangs etwa auf $V_{DD}$ gehalten wird. Das entspricht dem nichtselektierten Zustand der Wortleitung 3, wobei die an ihr liegenden Speicherzellen, z.B. Z, nicht adressiert sind.

Die potentialmäßige Ansteuerung der Wortleitung 3 in Abhängigkeit von dem Potential, das sich am Ausgang 4 des Dekoders D nach dem Zeitpunkt t2 einstellt, geht im einzelnen wie folgt vor sich: Der zum Zeitpunkt t3 beginnende Anstieg von WA8 auf $V_{DD}$ sperrt den Transistor T8, wodurch die Wortleitung 3 vom Anschluß 6 abgeschaltet wird und in den Zustand des "floating" gelangt. Dem Anschluß 7 wird eine Ansteuerspannung WA7 zugeführt, die zwischen einem oberen Wert $V_{DD}$ und einem unteren Wert von z.B. -2 Volt alterniert. Vor t3 weist WA7 den oberen Wert $V_{DD}$ auf, während nach t3 ein Abfall auf -2 Volt eintritt. Setzt man voraus, daß der Ausgang 4 während des Adressiervorgangs auf dem $V_{DD}$ entsprechenden Potential verbleibt (Selektion von 3), so wird T5 beim Abfall von WA7 auf -2 Volt leitend, da sein Gate mit $V_{DD}$ angesteuert bleibt. Die Wortleitung 3 erhält jetzt über T5 und 7 eine definierte Spannung von -2 Volt zugeführt, so daß $C_{WL}$ von $V_{DD}$ auf -2 Volt umgeladen wird, wie der Verlauf WL der Spannung auf der Wortleitung 3 zeigt. Als Folge davon wird der Auswahltransistor soweit in den leitenden Zustand ausgesteuert, daß er die leitende Verbindung zwischen C1 und der auf 0 Volt liegenden Bitleitung BL nicht nur dann aufrechterhält, wenn sich der Knoten 13 auf einem Potential befindet, das $V_{DD}$ entspricht, sondern auch dann, wenn sich 13 auf 0 Volt entladen hat.

Auf diese Weise gelingt es, die vorher auf $V_{DD}$ aufgeladene Speicherkapazität C1 auf 0 Volt umzuladen, wenn die auf 0 Volt liegende Bitleitung BL über T1 an den Knoten 13 angeschaltet wird. Bei herkömmlichen Schaltungen dieser Art, bei denen die Wortleitung 3 im selektierten Zustand nur auf 0 Volt abgesenkt wird, bleibt bei einer entsprechenden Umladung von C1 am Knoten 13 eine Restspannung bestehen, die dem Wert der Einsatzspannung von T1, also z.B. 1,5 Volt, entspricht.

Im betrachteten selektierten Zustand der Wortleitung 3 ist der Transistor T6 wegen der Spannung $V_{DD}$ am Ausgang 4 und seinem auf Bezugspotential liegenden Gate leitend. Zum Zeitpunkt t4 wird der Adressiervorgang beendet. Hierzu wird die Ansteuerspannung WA7 wieder auf $V_{DD}$ angehoben, so daß T5 sperrt, während WA8 auf 0 Volt abgesenkt wird, so daß die Spannung WL auf der Wortleitung 3 über den leitenden Transistor 78 auf $V_{DD}$ ansteigt (Fig. 2).

Wenn sich der Ausgang 4 des Dekoders D bei einer Nicht-Selektion der Wortleitung 3 (Verlauf 12 von $A_i$) nach $t_2$ über wenigstens einen leitend geschalteten Transistor T31 bis T3n auf 0 Volt entlädt, bleibt T5 während des Absinkens von WA7 nach dem Zeitpunkt t3 gesperrt. Auch wenn WA7 den unteren Spannungswert von -2 Volt erreicht, wird über die Kapazität C eine entsprechende Spannungsabsenkung auf das Gate von T5 übertragen, so daß dieser auch dann sicher sperrt. Der Transistor T6 sperrt beim Auftreten dieser Spannungsabsenkung, so daß das Gate von T5 nicht etwa über den oder die leitenden Transistoren T31 bis T3n auf 0 Volt angehoben wird (was dazu führen könnte, daß T5 wieder leitet). Die Spannung WL auf der Wortleitung 3 bleibt in diesem Fall während des ganzen Adressiervorgangs in dem bereits beschriebenen Zustand des "floating", und zwar auf einem Spannungspegel von $V_{DD}$, was in Fig. 2 durch den gestrichelten Verlauf 14 von WL angedeutet ist. Zum Zeitpunkt t4 wird der Adressiervorgang wieder beendet, was durch einen Anstieg der Ansteuerspannung WA7 auf $V_{DD}$ und einen Abfall der Spannung WAS auf 0 Volt geschieht. Damit wird die Wortleitung 3 über den leitenden Transistor T8 mit der Versorgungsspannung $V_{DD}$ beschaltet, während sich am gesperrten Zustand von T5 nichts ändert.

Eine bevorzugte Weiterbildung der Erfindung besteht darin, daß die Wortleitung 3 über einen p-Kanal-Transistor T4 mit dem Anschluß 6 verbunden ist, wobei das Gate von T4 an den Ausgang 4 des Dekoders D geschaltet ist. Die Anschlußleitungen von T4 sind in Fig. 1 gestrichelt eingezeichnet. Mit T4 wird erreicht, daß die Wortleitung 3 im nichtselektierten Zustand, in dem der Ausgang 4 auf 0 Volt abgesenkt wird, über den dann leitenden Transistor T4 mit der Versorgungsspannung $V_{DD}$ beschaltet ist, so daß der oben beschriebene Zustand des "floating" der Wortleitung durch die Anschaltung an ein definiertes Potential ersetzt ist. Der Vorteil besteht darin, daß Einkopplungen von Störspannungen nicht zu einer unerwünschten Selektion der Wortleitung 3 führen können.

Nach einer anderen Weiterbildung der Erfindung ist ein p-Kanal-Transistor T7 zwischen den Anschluß 6 und den Ausgang 4 des Dekoders D geschaltet, dessen Gate mit der Wortleitung 3 verbunden ist. T7 leitet im selektierten Zustand der Wortleitung, deren Potential dabei auf -2 Volt abgesenkt ist, und schaltet $V_{DD}$ auf den Ausgang 4 und damit auf das Gate von T5. Damit wird verhindert, daß sich der Ausgang 4 bei einer lange andauernden Selektion der Wortleitung 3 durch eventuelle Leckströme entlädt.

Bei der erfindungsgemäßen Schaltung kann es auch zweckmäßig sein, den Ausgang 4 des Dekoders D über einen n-Kanal-Transistor T9 mit dem Bezugspotential zu beschalten. Der Gateanschluß 9 von T9 ist dabei mit einer Spannung V9 belegt, die in Fig. 2 dargestellt ist. Wird V9 vor dem Beginn der ansteigenden Flanke von WA7, d.h. vor t4, von 0 Volt auf einen Wert $V_{DD}$ angehoben, so leitet T9 und verhindert eine dieser Flanke entsprechende Spannungserhöhung am Ausgang 4 bzw. am Gate von T5 über den Wert von $V_{DD}$ hinaus. Eine solche Spannungserhöhung könnte zur Ausbildung von unerwünschten Strompfaden in der Schaltung und damit zu einer thermischen Überlastung derselben führen.

Neben den oben beschriebenen Ausführungsformen der Erfindung sind auch solche von Interesse, bei denen die bisher verwendeten Transistoren des einen Kanaltyps jeweils durch solche des anderen Kanaltyps ersetzt sind, wobei anstelle der bisher genannten Spannungen bzw. Spannungswerte solche des jeweils entgegengesetzten Vorzeichens verwendet werden. Während sich die bisher beschriebenen Speicherzellen Z einschließlich der p-Kanal-Auswahltransistoren T1 jeweils in individuell zugeordneten n-leitenden wannenförmigen Teilgebieten eines p-leitenden Halbleiterkörpers befinden, auf dem der Speicher aufgebaut ist, sind die hiernach abgewandelten Speicherzellen mit n-Kanal-Auswahltransistoren ausgestattet und in p-leitenden wannenförmigen Teilgebieten eines n-leitenden Halbleiterkörpers vorgesehen.

## Ansprüche

1. Integrierte Schaltung eines in komplementärer Schaltungstechnik aufgebauten, dynamischen Halbleiterspeichers mit wahlfreiem Zugriff, bei dem die Speicherzellen über Auswahltransistoren eines ersten Kanaltyps mit zugeordneten Bitleitungen verbunden sind und bei der die Selektion der Auswahltransistoren mittels Wortleitungen erfolgt, die jeweils über einen ersten Schalttransistor eines zweiten Kanaltyps vom Ausgang eines Dekoders ansteuerbar sind, **dadurch gekennzeichnet,** daß eine Wortleitung (3) über den ersten Schalttransistor (T5) mit einem ersten Anschluß (7) verbunden ist, dem eine zwischen zwei Spannungswerten unterschiedlichen Vorzeichens alternierende Ansteuerspannung (WA7) zugeführt wird, und daß das Gate des ersten Schalttransistors (T5) über eine Kapazität (C) mit dem ersten Anschluß (7) und über einen zweiten Schalttransistor (T6) des ersten Kanaltyps, dessen Gate auf einem Bezugspotential liegt, mit dem Ausgang (4) des Dekoders (D) beschaltet ist.

2. Integrierte Schaltung nach Anspruch 1, **dadurch gekennzeichnet,** daß die Wortleitung (3) über einen dritten, vom Ausgang (4) des Dekoders (D) ansteuerbaren Schalttransistor (T4) des ersten Kanaltyps mit einem zweiten Anschluß (6) verbunden ist, dem eine Versorgungsspannung ($V_{DD}$) zugeführt wird.

3. Integrierte Schaltung nach Anspruch 1 oder 2, **dadurch gekennzeichnet,** daß der Ausgang (4) des Dekoders (D) über einen vierten Schalttransistor (T7) des ersten Kanaltyps mit dem zweiten Anschluß (6) verbunden ist, wobei das Gate des vierten Schalttransistors (T7) an der Wortleitung (3) liegt.

4. Integrierte Schaltung nach einem der Ansprüche 2 oder 3, **dadurch gekennzeichnet,** daß die Wortleitung (3) über einen fünften Schalttransistor (T8) des ersten Kanaltyps mit dem zweiten Anschluß (6) verbunden ist, wobei das Gate des fünften Schalttransistors (T8) mit einer Spannung (WA8) beschaltet ist, die ihn jeweils dann sperrt, wenn durch die alternierende Ansteuerspannung (WA7) der erste Schalttransistor (T5) leitend ist.

5. Integrierte Schaltung nach einem der Ansprüche 1 bis 4, **dadurch gekennzeichnet,** daß der Ausgang (4) des Dekoders (D) über einen sechsten Schalttransistor (T9) des zweiten Kanaltyps mit einem auf Bezugspotential gelegten Anschluß verbunden ist, wobei das Gate des sechsten Schalttransistors (T9) mit Taktimpulsen (V9) beschaltet ist, die mit einer Flanke der alternierenden Ansteuerspannung (WA7) zeitlich zusammenfallen.

## Claims

1. Integrated circuit of a dynamic semiconductor memory constructed in complementary circuit technology and having random access, in which the memory cells are connected via selection transistors of a first channel type to associated bit lines and in which the selection of the selection transistors occurs by means of word lines which can be actuated in each case via a first switching transistor of a second channel type by the output of a decoder, characterised in that a word line (3) is connected via the first switching transistor (T5) to a first terminal (7), to which an actuation voltage (WA7) which alternates between two voltage values of different sign is fed, and in that the gate of the first switching transistor (T5) is connected via a capacitor (C) to the first terminal (7) and via a second switching transistor (T6) of the first channel type, the gate of which is connected to a reference potential, to the output (4) of the decoder (D).

2. Integrated circuit according to Claim 1, characterised in that the word line (3) is connected via a third switching transistor (T4) of the first channel type which can be actuated by the output (4) of the decoder (D), to a second terminal (6) to which a supply voltage (V_{DD}) is fed.

3. Integrated circuit according to Claim 1 or 2, characterised in that the output (4) of the decoder (D) is connected via a fourth switching transistor (T7) of the first channel type to the second terminal (6), the gate of the fourth switching transistor (T7) being connected to the word line (3).

4. Integrated circuit according to one of Claims 2 or 3, characterised in that the word line 3, is connected via a fifth switching transistor (T8) of the first channel type to the second terminal (6), the gate of the fifth switching transistor (T8) being connected to a voltage (WA8) which inhibits it whenever the first switching transistor (T5) is conductive as a result of the alternating drive voltage (WA7).

5. Integrated circuit according to one of Claims 1 to 4, characterised in that the output (4) of the decoder (D) is connected via a sixth switching transistor (T9) of the second channel type to a terminal connected to reference potential, the gate of the sixth switching transistor (T9) being connected to clock pulses (V9) which coincide in time with an edge of the alternating drive voltage (WA7).

**Revendications**

1. Circuit intégré d'une mémoire dynamique à semiconducteurs à accès direct, réalisé selon la technique des circuits complémentaires, dans lequel les cellules de mémoire sont raccordées par l'intermédiaire de transistors de sélection possédant un canal du premier type à des lignes associées de transmission de bits, et dans lequel la sélection de transistors de sélection est réalisée à l'aide de lignes de transmission de mots, qui peuvent être commandées respectivement par l'intermédiaire d'un premier transistor de commutation possédant un canal du second type, à partir de la sortie d'un décodeur, caractérisé par le fait qu'une ligne de transmission de mots (3) est raccordée, par l'intermédiaire du premier transistor de commutation (T5), à une première borne (7), à laquelle est envoyée une tension de commande (WA7) qui alterne entre deux valeurs possédant des signes différents, et que la grille du premier transistor de commutation (T5) est raccordée par une capacité (C) à la première borne (7) et par un second transistor de commutation (T6) possédant un canal du premier type et dont la grille a été placée à un potentiel de référence, à la sortie (4) du décodeur (D).

2. Circuit intégré suivant la revendication 1, caractérisé par le fait que la ligne de transmission de mots (3) est raccordée par un troisième transistor de commutation (T4) possédant un canal du premier type et pouvant être commandé par la sortie (4) du décodeur (D), à une seconde borne (6), à laquelle est envoyée une tension d'alimentation (V_{DD}).

3. Circuit intégré suivant la revendication 1 ou 2, caractérisé par le fait que la sortie (4) du décodeur (D) est raccordée par un quatrième transistor de commutation (T7) possédant un canal du premier type, à la seconde borne (6), la grille du quatrième transistor de commutation (T7) étant raccordée à la ligne de transmission de mots (3).

4. Circuit intégré suivant l'une des revendications 2 ou 3, caractérisé par le fait que la ligne de transmission de mots (3) est raccordée par un cinquième transistor de commutation (T8) possédant un canal du premier type à la seconde borne (6), la grille du cinquième transistor de commutation (T8) étant raccordée à une tension (WA8) qui le bloque respectivement lorsque le premier transistor de commutation (T5) est conducteur sous l'effet de la tension alternative de commande (WA7).

5. Circuit intégré suivant l'une des revendications 1 à 4, caractérisé par le fait que la sortie (4) du détecteur (D) est raccordée par un sixième transistor de commutation (T9) possédant un canal du second type, à une borne raccordée au potentiel de référence, la grille du sixième transistor de commutation (T9) recevant des impulsions de cadence (V9) qui coïncident dans le temps avec un flanc de la tension alternative de commande (WA7).

FIG 1

FIG 2